# EUROPEAN PATENT APPLICATION

(11) **EP 1 441 573 A2**
(43) Date of publication of application: **28.07.2004**
(21) Application number: 04001343.5
(22) Date of filing: 22.01.2004
(51) Int. Cl.: H05B 33/08, H01L 51/20

(54) **Organic electroluminiscent device**

(30) Priority: 23.01.2003 JP 2003014113
(71) Applicant: Kabushiki Kaisha Toyota Jidoshokki, Kariya-shi, Aichi-ken (JP)
(72) Inventor: Koide, Naotaka, Kariya-shi, Aichi-ken (JP); Kato, Yoshifumi, Kariya-shi, Aichi-ken (JP)
(74) Representative: Leson, Thomas Johannes Alois, Dipl.-Ing.

(57) **Abstract**

An organic electroluminescent device that is capable of changing the gradation of emitted light without changing the chromaticity of the light. The organic electroluminescent device according to the present invention has an organic electroluminescent element and a drive unit. The organic electroluminescent element has a pair of electrodes and an electroluminescent layer provided between the electrodes. The electroluminescent layer contains at least two types of phosphorescent materials. Each phosphorescent material emits light the color of which is different from the color of light emitted by the other phosphorescent material. The drive unit is electrically connected to the organic electroluminescent element. The drive unit supplies to the organic electroluminescent element a current that has a modulated pulse width and a constant amplitude, thereby causing the organic electroluminescent element to emit light.

## Description

### BACKGROUND OF THE INVENTION

The present invention relates to an organic electroluminescent device having an organic electroluminescent element and a drive unit connected to the organic electroluminescent element electrically.

An organic electroluminescent element emits light when receiving from a drive unit a current having a predetermined current density. Some organic electroluminescent elements have two or more electroluminescent layers that emit light of different colors. Light emitted by such an element is a composite light of light emitted by respective electroluminescent layers. Each electroluminescent layer contains a host material and a small amount of doped luminous material such as a fluorescent material and a phosphorescent material. The color of light emitted by each electroluminescent layer is determined by the type of the luminous material contained in the layer.

A phenomenon is thought that, as the current density of current supplied from the drive unit to an organic electroluminescent element is increased, the luminous efficiency of electroluminescent layers is lowered. This phenomenon was reported, for example, by M. A. Baldo, C. Adachi, and S. R. Forrest in an article titled "Transient analysis of organic electrophosphorescence" on pages 10967 to 10977 in Number 16 of Volume 62 of "Physical Review B" issued by The American Physical Society on October 15, 2000. The phenomenon occurs because, if the current density is great, excitons generated in an electroluminescent layer due to recombination of holes and electrons collide one another, and, as a result, the energy of the excitons is prevented from being transmitted to the luminous material. The phenomenon is referred to as concentration quenching. Particularly, when a phosphorescent material is used as the luminous material, the phenomenon is referred to as T-T annihilation, and when a fluorescent material is used as the luminous material, the phenomenon is referred to as S-S annihilation.

The luminous efficiency, which is also referred to as quantum efficiency, is computed by multiplying the injection efficiency of holes or electrons into the electroluminescent layer by the internal quantum efficiency and a coefficient. When a fluorescent material is used as the luminous material, the coefficient is 0.25, which represents the ratio of the singlet in electrons in a spin state at ordinary temperatures. When a phosphorescent material is used as the luminous material, the coefficient is one, which is the ratio of the singlet and triplet in electrons in a spin state at ordinary temperatures.

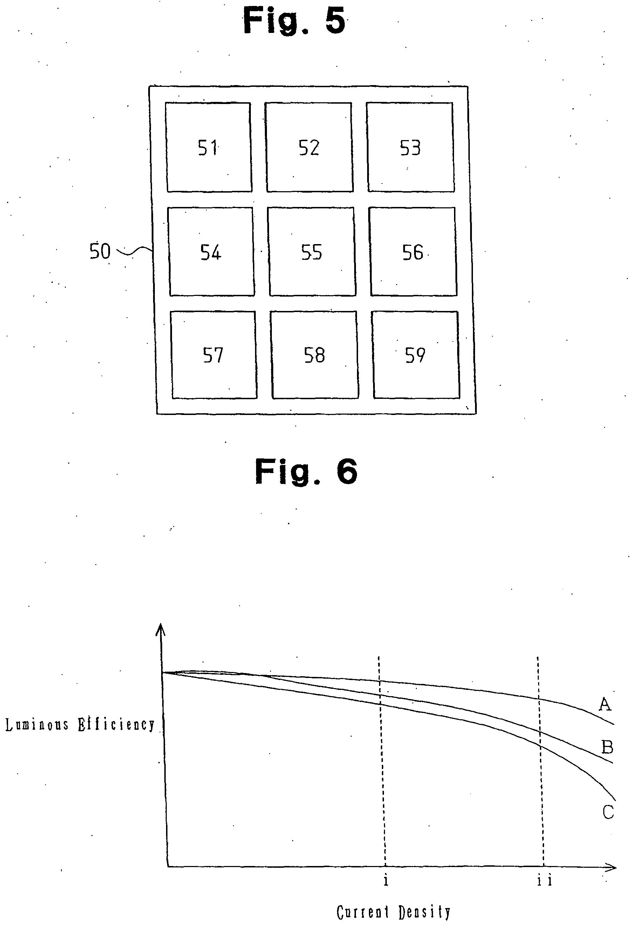

Fig. 6 is a graph showing the relationship between the luminous efficiency of three electroluminescent layers A, B, and C and the current density of a supplied current. Each of the electroluminescent layers A-C contains one of three luminous materials that emit light of different colors. As shown in Fig. 6, the luminous efficiency is decreased by a greater degree according to an increase in the current density when the current density is high than when the current density is low. Further, the rate of decrease in the luminous efficiency due to an increase in the current density differs from one luminous material to another. Therefore, an organic electroluminescent element having the electroluminescent layers A-C has the following drawback. That is, when the current density is changed to change the gradation of brightness of emitted light, for example, when the current density is changed from the value represented by a mark ii to the value represented by a mark i, not only the gradation of brigtness of emitted light, but also the chromaticity, of the emitted light are changed. This is particularly noticeable in organic electroluminescent elements that have electroluminescent layers containing a phosphorescent material, and in organic electroluminescent elements that have electroluminescent layers containing a fluorescent material when the elements receive a current of a current density equal to or greater than 1 A/cm².

For example, in cases of an organic electroluminescent device such as a supersized display and a floodlight lamp driven by a passive matrix system, a current having a current density that is equal to or greater than 1 A/cm² is used to obtain a sufficient brightness. However, a current having a current density that is equal to or greater than 1 A/cm² significantly degrades the luminous efficiency of electroluminescent layers containing a fluorescent material.

### SUMMARY OF THE INVENTION

Accordingly, it is an objective of the present invention to provide an organic electroluminescent device that is capable of changing the gradation of brigtness of emitted light without changing the chromaticity of the light.

To achieve the foregoing and other objectives and in accordance with the purpose of the present invention, an organic electroluminescent device having an organic electroluminescent element and a drive unit is provided. The organic electroluminescent element has a pair of electrodes and an electroluminescent layer provided between the electrodes. The electroluminescent layer contains at least two types of phosphorescent materials. Each phosphorescent material emits light the color of which is different from the color of light emitted by the other phosphorescent material. The drive unit is electrically connected to the organic electroluminescent element. The drive unit supplies to the organic electroluminescent element a current that has a modulated pulse width and a constant amplitude, thereby causing the organic electroluminescent element to emit light.

According to the present invention, another organic electroluminescent device having an organic electroluminescent element and a drive unit is provided. The organic electroluminescent element has a pair of electrodes and an electroluminescent layer provided between the electrodes. The electroluminescent layer contains at least two types of phosphorescent materials. Each phosphorescent material emits light the color of which is different from the color of light emitted by the other phosphorescent material. The drive unit is electrically connected to the organic electroluminescent element. The drive unit controls the gradation of brightness of the organic electroluminescent element by an area gradation method.

The present invention provides another organic electroluminescent device having an organic electroluminescent element and a drive unit. The organic electroluminescent element has a pair of electrodes and at least two electroluminescent layers provided between the electrodes. Each electroluminescent layer contains a phosphorescent material. The phosphorescent material contained in each electroluminescent layer emits light the color of which is different from the color of light emitted by the phosphorescent material of the other electroluminescent layer. The drive unit is electrically connected to the organic electroluminescent element. The drive unit supplies to the organic electroluminescent element a current pulse having a modulated pulse width and a constant amplitude, thereby causing the organic electroluminescent element to emit light.

According to another aspect of the invention, an organic electroluminescent device having an organic electroluminescent element and a drive unit is provided. The organic electroluminescent element has a pair of electrodes and at least two electroluminescent layers provided between the electrodes. Each electroluminescent layer contains a phosphorescent material. The phosphorescent material contained in each electroluminescent layer emits light the color of which is different from the color of light emitted by the phosphorescent material of the other electroluminescent layer. The drive unit is electrically connected to the organic electroluminescent element. The drive unit controls the gradation of brightness of the organic electroluminescent element by an area gradation method.

Further, the present invention provides another organic electroluminescent device having an organic electroluminescent element and a drive unit. The organic electroluminescent element has a pair of electrodes and an electroluminescent layer provided between the electrodes. The electroluminescent layer contains at least two types of fluorescent materials. Each fluorescent material emits light the color of which is different from the color of light emitted by the other fluorescent material. The drive unit is electrically connected to the organic electroluminescent element. The drive unit supplies to the organic electroluminescent element a current pulse that has a modulated pulse width, a constant amplitude, and a current density equal to or more than 1 A/cm², thereby causing the organic electroluminescent element to emit light.

The present invention also provides another organic electroluminescent device having an organic electroluminescent element and a drive unit. The organic electroluminescent element has a pair of electrodes and an electroluminescent layer provided between the electrodes. The electroluminescent layer contains at least two types of fluorescent materials. Each fluorescent material emits light the color of which is different from the color of light emitted by the other fluorescent material. The drive unit is electrically connected to the organic electroluminescent element. The drive unit controls the gradation of brightness of the organic electroluminescent element by an area gradation method.

In another aspect of the present invention, another organic electroluminescent device having an organic electroluminescent element and a drive unit is provided. The organic electroluminescent element has a pair of electrodes and at least two electroluminescent layers provided between the electrodes. Each electroluminescent layer contains a fluorescent material. The fluorescent material contained in each electroluminescent layer emits light the color of which is different from the color of light emitted by the fluorescent material of the other electroluminescent layer. The drive unit is electrically connected to the organic electroluminescent element. The drive unit supplies to the organic electroluminescent element a current pulse that has a modulated pulse width, a constant amplitude, and a current density equal to or more than 1 A/cm², thereby causing the organic electroluminescent element to emit light.

The present invention further provides an organic electroluminescent device having an organic electroluminescent element and a drive unit. The organic . electroluminescent element has a pair of electrodes and at least two electroluminescent layers provided between the electrodes. Each electroluminescent layer contains a fluorescent material. The fluorescent material contained in each electroluminescent layer emits light the color of which is different from the color of light emitted by the fluorescent material of the other electroluminescent layer. The drive unit is electrically connected to the organic electroluminescent element. The drive unit controls the gradation of brightness of the organic electroluminescent element by an area gradation method.

Other aspects and advantages of the invention will become apparent from the following description, taken in conjunction with the accompanying drawings, illustrating by way of example the principles of the invention.

### BRIEF DESCRIPTION OF THE DRAWINGS

Fig. 1 is a schematic view showing an organic electroluminescent device according to a first embodiment of the present invention;
Fig. 2 is a diagram showing the display-period-separated (DPS) method;
Fig. 3 is a circuit diagram showing a drive unit used for the DPS method;
Fig. 4(a) is a circuit diagram showing a drive unit used for the simultaneous-erasing-scan (SES) method;
Fig. 4(b) is a diagram showing the SES method;
Fig. 5 is a diagram showing sub-pixels the gradation of which is controlled by a method of area gradation; and
Fig. 6 is a graph showing the relationship between the luminous efficiency of electroluminescent layers A, B, and C and the current density of a supplied current.

### DETAILED DESCRIPTION OF THE PREFERRED EMBODIMENTS

A first embodiment of the present invention will now be described.

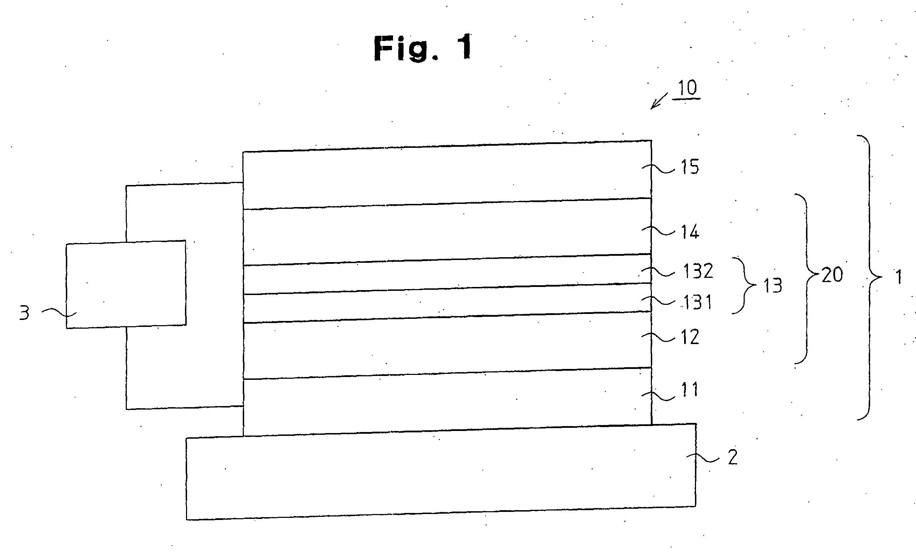

As shown in Fig. 1, an organic electroluminescent device 10 according to this embodiment has an organic electroluminescent element 1, a substrate 2, and a drive unit 3. The organic electroluminescent element 1 (organic light emitting diode) is located on the substrate 2 and has an anode 11, an organic layer 20, and a cathode 15. The organic layer 20 is located between the anode 11 and the cathode 15, and includes a hole injection transport layer 12, a light emitting layer 13, and an electron injection transport layer 14. The layers 12, 13, and 14 are arranged in this order from a part of the organic layer 20 that contacts the anode 11 to a part of the organic layer 20 that contacts the cathode 15. The drive unit 3, which includes an external power supply, is electrically connected to the anode 11 and the cathode 15.

The organic electroluminescent device 10 may be any of a top emission type, a bottom emission type, and a top-and-bottom emission type. If the organic electroluminescent device 10 is a top emission type, light emitted by the light emitting layer 13 exits the device 10 from a surface of the light emitting element that is opposite from a surface facing the substrate 2. If the organic electroluminescent device 10 is a bottom emission type, light emitted by the light emitting layer 13 exits the device 10 from a surface of the substrate 2 that is opposite from a surface facing the organic electroluminescent element 1. If the organic electroluminescent device 10 is a top-and-bottom emission type, light emitted by the light emitting layer exits the device 10 from a surface of the organic electroluminescent element 1 that is opposite from a surface facing the substrate 2, and from a surface of the substrate 2 that is opposite from a surface facing the organic electroluminescent element 1.

The organic electroluminescent element 1 is formed on the substrate 2. To flatten the organic electroluminescent element 1, the surface of the substrate 2 is preferably flat and smooth. The substrate 2 is formed of, for example, glass, silicon, ceramics such as quartz, plastic, or metal. The substrate 2 may be formed of a single material. Alternatively, the substrate 2 may be formed by combining two or more similar materials or different materials. For example, the substrate 2 may be formed by overlaying a metal foil on a plastic base. However, if the organic electroluminescent device 10 is a bottom emission type or a top-and-bottom emission type, the substrate 2 must permit light emitted by the light emitting layer 13 to pass through. In this case, the light transmittance of the substrate 2 is preferably equal to or more than 50%.

If made of glass, the substrate 2 is superior in heat resistance, moisture permeability, and surface smoothness. Specifically, the substrate 2 is made of, for example, blue sheet glass, white sheet glass, or quartz glass. If made of plastic, the substrate 2 is thin, light, hard to break, and flexible or bendable. Examples of preferable plastics include polyethylene, polypropylene, polyester, polysulfone, polyamide, polycarbonate, polyethylene terephthalate, polyethylene naphthalate, polyethersulfone, polyether sulfide, cyclo-olefin polymer, and polymethyl methacrylate. These plastics are superior in smoothness, heat resistance, solvent resistance, dimensional stability, impact resistance, moisture resistance, and oxygen barrier property. If made of plastic, the substrate 2 may be formed by casting. If formed by casting plastic, the substrate 2 is superior in surface smoothness. When made of silicon, the substrate 2 reduces the size of the organic electroluminescent device 10. This is because, if the substrate 2 is made of silicon, the drive unit 3 can be mounted on the substrate 2. In this case, the applicability of the organic electroluminescent device 10 is expanded to high-definition microdisplays.

A thin film of silica aerogel that has a low refractive index may be formed on the substrate 2. The silica aerogel improves the ratio of the amount of light that exits the device 10 to the amount of light emitted by the light emitting layer 13. Alternatively, a color filter, a color conversion film, a dielectric reflection film, or an inorganic derivative film may be formed on the substrate 2. In this case, the properties of light that exists the device 10 are changed.

A protective layer for preventing metal ions in the substrate 2 from diffusing into the organic electroluminescent element 1 may be provided between the substrate 2 and the organic electroluminescent element 1. Particularly, if the substrate 2 is made of blue sheet glass, it is preferable to provide a passivation film containing inorganic material such as SiO₂ to prevent alkali metal ions and alkaline earth metal ions from diffusing into the organic electroluminescent element 1. If the substrate 2 is made of plastic, to improve the moisture resistance, a passivation film such as a silicon nitride film, a silicon oxide film, or a silicon oxide nitride film may be provided on the surface of the substrate 2.

The anode 11 functions to inject holes into the hole injection transport layer 12. The anode 11 is formed of an electroconductive material. Examples of the electroconductive materials include: metallic oxide such as indium tin oxide (ITO), indium zinc oxide (IZO), tin oxide, zinc oxide, and zinc aluminum oxide; metal nitride such as titanium nitride; metal such as gold, platinum, silver, copper, aluminum, nickel, cobalt, lead, chromium, molybdenum, tantalum, and niobium; an alloy containing these metals or copper iodide; and a conductive high polymer such as polyaniline, polythiophene, polypyrrole, polyphenylene vinylene, poly(3-methylthiophene), and polyphenylene sulfide. The anode 11 may be made of a single material or of two or more materials. Alternatively, the anode 11 may be formed by combining two or more similar materials or different materials.

If the organic electroluminescent device 10 is a bottom emission type or a top-and-bottom emission type, the anode 11 must permit light emitted by the.light emitting layer 13 to pass through. In this case, the light transmittance of the anode 11 is preferably greater than 10%, and more preferably greater than 50%. In a case where visible light emitted by the light emitting layer 13 exits the device 10 from a surface of the substrate 2 that is opposite from a surface facing the organic electroluminescent element 1, the anode 11 is preferably made of ITO. On the other hand, if the organic electroluminescent device 10 is a top emission type, the . anode 11 is preferably capable of reflecting light emitted by the light emitting layer 13. If the device 10 is a top emission type and the anode 11 passes through light emitted by the light emitting layer 13, it is preferable that the substrate 2 be capable of reflecting light emitted by the light emitting layer 13 or that a reflection layer for reflecting light emitted by the light emitting layer 13 be provided between the anode 11 and the substrate 2.

The anode 11 is formed by a conventional method for forming thin films, such as sputtering, ion plating, vacuum deposition, spin coating, and electronic beam evaporation. The surface of the anode 11 is preferably subjected to ozone cleaning or oxygen plasma cleaning. This is because, after being subjected to ozone cleaning or oxygen plasma cleaning, the surface of the anode 11 has a high work function. The mean square value of the surface roughness of the anode 11 is preferably equal to or less than 20 nm so that defects like short circuits are reduced. The surface roughness of the anode 11 can be decreased by forming the anode 11 with material of a minute particle diameter, or by grinding the surface of the formed anode 11. The thickness of the anode 11 is preferably between 5 nm and 1 µm, more preferably between 10 nm and 1 µm, further preferably between 10 nm and 500 nm, yet further preferably 10 nm and 300 nm, and most preferably between 10 nm and 200 nm. The electric resistance of the anode 11 is preferably equal to or less than several hundreds of ohms/sheet, and more preferably between 0.5 ohms/sheet and 50 ohms/sheet. The anode 11 may have an auxiliary electrode. The auxiliary electrode may be formed metal such as copper, chromium, aluminum, titanium, and aluminum alloy. Alternatively, the auxiliary electrode may be formed by laminating these metals. Attaching the auxiliary electrode to a part of the anode 11 reduces the resistance of the anode 11.

The hole injection transport layer 12 is provided between the anode 11 and the light emitting layer 13. The hole injection transport layer 12 receives holes injected from the anode 11 and transports the injected holes to the light emitting layer 13. The ionization energy of the hole injection transport layer 12 is between the work function of the anode 11 and the ionization energy of the light emitting layer 13. The ionization energy of the hole injection transport layer 12 is, for example, between 5.0 eV and 5.5 eV. The hole injection transport layer 12 provides the following four advantages to the organic electroluminescent element 1. The first advantage is that, since energy barrier against transportation of holes from the anode 11 to the light emitting layer 13 is lowered, the drive voltage of the organic electroluminescent element 1 is lowered. The second advantage is that, since the injection and transportation of holes from the anode 11 to the light emitting layer 13 is stabilized, the life of the organic electroluminescent element 1 is extended. The third advantage is that, since the anode 11 intimately contacts the organic layer 20, the homogeneity of the light emitting surface of the organic electroluminescent element 1 is improved. The fourth advantage is that, since projections on the surface of the anode 11 are covered, the yield is improved.

The hole injection transport layer 12 is formed of, for example, one or more of a phthalocyanine derivative, a triazole derivative, a triarylmethane derivative, a triarylamine derivative, a oxazole derivative, an oxiadiazole derivative, a hydrazone derivative, a stilbene derivative, a pyrazoline derivative, a pyrazolone derivative, a polysilane derivative, an imidazole derivative, a phenylenediamine derivative, an amino group replaced chalcone_derivative, a styryl anthracene' derivative, a fluorenone derivative, a hydrazone derivative, a silazane derivative, an aniline copolymer, a porphyrin compound, a polyarylalkane derivative, polyphenylenevinylene or its derivative, polythiophene or its derivative, a poly-N-vinylcarbazole derivative, a conductive high polymer oligomer such as thiophene oligomer, metal phthalocyanine such as copper phthalocyanine and tetra (t-butyl) copper phthalocyanine, metal-free phthalocyanine, a quinacridone compound, an aromatic tertiary amine compound, a styrylamine compound, and an aromatic dimethylidyne compound.

Examples of the triarylamine derivative include 4, 4'-bis[N-phenyl-N-(4"-methylphenyl) amino] biphenyl, 4, 4'-bis [N-phenyl-N-(3"-methylphenyl) amino] biphenyl, 4, 4'-bis [N-phenyl-N-(3"-methoxyphenyl) amino] biphenyl, 4, 4'-bis [N-phenyl-N-(1"-naphthyl) amino] biphenyl, 3, 3'-dimethyl-9,4'-bis [N-phenyl-N-(3"-methylphenyl) amino] biphenyl, 1,1-bis[4'-[N,N-di(4"-methylphenyl) amino] phenyl] cyclohexane, 9,10-bis[N-(4'-methylphenyl)-N-(4"-n-butylphenyl) amino] phenanthrene, 3,8-bis[N,N-diphenylamino)-6-phenylphenanthridine, 4-methyl-N, N-bis[4",4"'-bis[N',N"-di (4-methylphenyl) amino]biphenyl-4-yl] aniline, N,N"-bis[4-(diphenylamino)phenyl]-N, N'-diphenyl-1,3-diaminobenzene, N,N' -bis[4- (diphenylamino)phenyl]-N, N'-diphenyl-1,4-diaminobenzene, 5, 5"-bis [4-(bis [4-methylphenyl]amino)phenyl]-2,2' :5' ,2"-terthiophene, 1,3,5-tris(diphenylamino)benzene, 4,4',4",-tris(N-carbazolyl)triphenylamine, 9,4',4'',-tris(N-3'''-methylphenyl)-N-phenylamino]triphenylamine, 4,4',4",-tris(N,N-bis(4'''-tert- butylbiphenyl-4""-yl)amino]triphenylamine, and 1,3,5-tris[N-(4'-diphenylaminophenyl) -N-phenylamino]benzene.

Examples of the porphyrin compound include porphin, 1,10,15,20-tetraphenyl-21H,23H-porphin copper (II), 1,10,15,20-tetraphenyl-21H,23H- porphin zinc (II), 5,10,15,20-tetrakis(pentafluorophenyl)-21H,23H-porphin, silicon phthalocyanine oxide, aluminum phthalocyanine chloride, metal-free phthalocyanine, dilithium-phthalocyanine, copper tetramethyl phthalocyanine, copper phthalocyanine, chromium phthalocyanine, zinc phthalocyanine, lead phthalocyanine, titanium phthalocyanine oxide, magnesium phthalocyanine, and copper octamethyl phthalocyanine.

Examples of the aromatic tertiary amine compound and the styrylamine compound include N,N,N',N'-tetraphenyl-4,4'-diaminophenyl, N,N'-diphenyl-N,N'-bis-(3-methylphenyl)-[1,1'-biphenyl]-4,4'-diamine, 2,2-bis(4-di-p-tolylaminophenyl)propane, 1,1-bis(4-di-p-tolylaminophenyl)cyclohexane, N,N,N',N'-tetra-p-tolyl-9,4'-diaminophenyl, 1,1-bis(4-di-p-tblylaminophenyl)-4-phenylcyclohexane, bis(4-dimethylamino-2-methylphenyl)phenylmethane, bis(4-di-p-tolylaminophenyl) phenylmethane, N,N'-diphenyl-N,N'-di(4-Methoxyphenyl)-4,4'-diaminobiphenyl, N,.N,N',N'-tetraphenyl-4,4'-diaminophenyl ether, 4,4'-bis(diphenylamino)quadriphenyl, N,N,N-tri(p-tolyl)amine, 4-(di-p-tolylamino)-4'-[4(di-p-tolylamino) styryl]stilbene, 4-N,N-diphenylamino-(2-diphenylvinyl)benzene, 3-methoxy -4'-N,N-diphenylaminostilbenzene, and N-phenylcarbazole.

The hole injection transport layer 12 may be made of a single material or of two or more materials. Alternatively, the hole injection transport layer 12 may be formed by combining two or more similar materials or different materials. If the organic electroluminescent device 10 is a bottom emission type or a top-and-bottom emission type, the hole injection transport layer 12 must permit light emitted by the light emitting layer 13 to pass through. In this case, the light transmittance of the hole injection transport layer 12 is preferably greater than 10%, and more preferably greater than 50%. The hole injection transport layer 12 is formed by a conventional method for forming thin films, such as vacuum deposition, spin coating, casting, and the Langmuir-Blodgett (LB) method. The thickness of the hole injection transport layer 12 is preferably between 5 nm and 5 µm.

The light emitting layer 13 has at least two electroluminescent layers. In this embodiment, the light emitting layer 13 has a first electroluminescent layer 131 and a second electroluminescent layer 132. The electroluminescent layers 131, 132 have different peak wavelengths, or emit light of different colors. If the light emitting layer 13 has third electroluminescent layer other than the first and second electroluminescent layers 131, 132, the color of light emitted by the third electroluminescent layer may be different from the colors of light emitted by the first and second electroluminescent layers 131, 132, or may be the same as the color of the light of one of the first and second electroluminescent layers 131, 132.

Each electroluminescent layer contains a host material and a dopant. The dopant is a phosphorescent material (a phosphorescent pigment or a phosphorescent dopant). The host material receives holes from the hole injection transport layer 12 and receives electrons from the electron injection transport layer 14. The host material is excited by recombination of the received holes and electrons. When excited, the host material passes energy to the nearby phosphorescent material. When receiving energy from the host material, the phosphorescent material generates singlet and triplet excitons. The generated excitons emit light during transition to the ground state at ordinary temperatures. The phosphorescent material contained in the first electroluminescent layer 131 emits light the color of which is different from light emitted by the phosphorescent material contained in the second electroluminescent layer 132. The doping ratio of the phosphorescent material to the host material is preferably between 0.01 wt% and 15 wt%.

Examples of the host material include a distyrylallylene derivative, a distyrylbenzene derivative, a distyrylamine derivative, a quinolinolato metal complex, a triarylamine derivative, an azomethine derivative, an oxadiazole derivative, a pyrazoloquinoline derivative, a silole derivative, a naphthalene derivative, an anthracene derivative, a dicarbazole derivative, a perylene derivative, an oligothiophene derivative, a coumarin derivative, a pyrene derivative, a tetraphenylbutadiene derivative, a benzopyran derivative, an europium complex, a rubrene derivative, a quinacridone derivative, a triazole derivative, a benzoxazole derivative, and a benzothiazole derivative. Among these materials, carbazole materials and bathocuproin are preferable due to a great energy gap, specifically a great triplet gap. A material having a high glass transition temperature is preferably used as the host material.

Examples of the phosphorescent material include phosphorescent heavy metal complexes. Particularly, examples of the phosphorescent material that emits green light include tris(2-phenylpyridine)iridium, examples of the phosphorescent material that emits red light include 2 ,3,7,8, 12,13,17, 18-octaethyl-21H23H-porphin platinum (II). The central metal of these heavy metal complexes may be replaced by other metal or nonmetal.

Each electroluminescent layer may contain only one type of phosphorescent material or two or more types of phosphorescent materials. Alternatively, each electroluminescent layer may contain a dopant that is not a phosphorescent material. In these cases, each electroluminescent layer emits light of mixed colors or light of two or more different colors. Also, the efficiency of energy transportation from the host material to the phosphorescent material may be improved.

Each electroluminescent layer is formed by a conventional method for forming thin films, such as vacuum deposition, spin coating, casting, and the LB method. The thickness of each electroluminescent layer is preferably between 1 nm and 100 nm, and more preferably between 2 nm and 50 nm.

Light emitted by the organic electroluminescent device 10 can be adjusted according to the type and quantity of the phosphorescent material contained in the electroluminescent layers and the thickness of each electroluminescent layer. For example, suppose that the light emitting layer 13 has a first electroluminescent layer containing phosphorescent material that emits red light, a second electroluminescent layer containing phosphorescent material that emits green light, and a third electroluminescent layer containing phosphorescent material that emits blue light. In this case, the color of light emitted by the light emitting layer 13 becomes white when the quantity of the phosphorescent materials contained in the electroluminescent layers and the thickness of each electroluminescent layer are properly set.

Light emitted by the organic electroluminescent device 10 can be adjusted by any of the following three methods. The first method is adding a material that changes the wavelength of light emitted by the light emitting layer 13 in a part of the device 10 between the light emitting layer 13 and the light emitting surface. The second method is adding a dopant that promotes or hinders emission of light to the light emitting layer 13. Examples of such a dopant include a mediate material that receives energy from the excited host material and passes the energy to the phosphorescent material. If the light emitting layer 13 contains such a mediate material, the efficiency of the transportation of energy from the host material to the phosphorescent material is improved. Examples of the mediate material include the materials listed above as examples of the host material and the phosphorescent material. The third method is providing a color filter in a part of the device 10 between the light emitting layer 13 and the light emitting surface. Examples of the color filter include a blue filter containing cobalt oxide, a green filter containing cobalt oxide and chromium oxide, and a red filter containing iron oxide. The color filter is formed by a conventional method for forming thin films, such as vacuum deposition.

The electron injection transport layer 14 is provided between the light emitting layer 13 and the cathode 15. The electron injection transport layer 14 receives electrons injected from the cathode 15 and transports the injected electrons to the light emitting layer 13. In general, the electron affinity of the electron injection transport layer 14 is between the work function of the cathode 15 and the electron affinity of the light emitting layer 13. The electron injection transport layer 14 provides the following four advantages to the organic electroluminescent element 1. The first advantage is that, since energy barrier against transportation of electrons from the cathode 15 to the light emitting layer 13 is lowered, the drive voltage of the organic electroluminescent element 1 is lowered. The second advantage is that, since the injection and transportation of electrons from the cathode 15 to the light emitting layer 13 is stabilized, the life of the organic electroluminescent element 1 is extended. The third advantage is that, since the cathode 15 intimately contacts the organic layer 20, the homogeneity of the light emitting surface of the organic electroluminescent element 1 is improved. The fourth advantage is that, since projections on the surface of the cathode 15 are covered, the yield is improved.

The electron injection transport layer 14 is formed of, for example, any of the following materials: an oxadiazole derivative such as 1,3-bis[5'-(p-tert-butylphenyl)-1,3,4-oxadiazole-2'-yl]benzene, 2-(4-biphenylyl)-5-(4-t-butylphenyl)-1,3,4-oxadiazole; a triazole derivative such as 3-(4'-tert-butylphenyl)-4-phenyl-5-(4"-biphenyl)-1,2,4-triazole; a triazine derivative; a perylene derivative; a quinoline derivative; a quinoxaline derivative; diphenylquinone derivative; a nitro group replaced fluorenone derivative; a thiopyran dioxide derivative; an anthraquino-dimethane derivative; a thiopyran dioxide derivative; a heterocyclic tetracarboxylic acid such as naphthalene perylene; carbodiimide; a fluorenylidene methane derivative; an anthraquino dimethane derivative; an anthrone derivative; a distyrylpyrazine derivative; an organometallic complex such as bis(10-benz[h]quinolinolato)beryllium, a ' beryllium salt of 5-hydroxyflavone, and an aluminum salt of 5-hydroxyflavone; a metal complex of 8-hydroxyquinoline or a metal complex of an 8-hydroxyquinoline derivative; and metal-free or metal phthalocyanine, or metal-free or metal phthalocyanine the end group of which is replaced by a alkyl group or a sulfone group. Among these materials, 8-hydroxyquinoline or a metal complex of an 8-hydroxyquinoline derivative, metal-free or metal phthalocyanine, or metal-free or metal phthalocyanine the end group of which is replaced by a alkyl group or a sulfone group are preferable. Examples of 8-hydroxyquinoline or a metal complex of an 8-hydroxyquinoline derivative include oxinoid chelated metal compound such as tris(8-quinolinol)aluminum, tris(5,7-dichloro-8-quinolinol) aluminum, tris(5,7-dibromo-8-quinolinol)aluminum, tris(2-methyl-8-quinolinol)aluminum. The central metal of these metal complexes may be replaced by indium, magnesium, copper, calcium, tin, or lead.

The electron injection transport layer 14 may be made of a single material or of two or more materials. Alternatively, the electron injection transport layer 14 may be formed by combining two or more similar materials or different materials. If the organic electroluminescent device 10 is a top emission type or a top-and-bottom emission type, the electron injection transport layer 14 must permit light emitted by the light emitting layer 13 to pass through. In this case, the light transmittance of the electron injection transport layer 14 is preferably greater than 10%, and more preferably greater than 50%. The electron injection transport layer 14 is formed by a conventional method for forming thin films, such as sputtering, ion plating, vacuum deposition, spin coating, and electronic beam evaporation. The thickness of the electron injection transport layer 14 is preferably between 5 nm and 5 µm.

The cathode 15 functions to inject electrons into the electron injection transport layer 14. To improve the injection efficiency of electrons into the electron injection transport layer 14, the work function of the cathode 15 is preferably less than 4.5 eV, more preferably equal to less than 4.0 eV, and most preferably equal to or less than 3.7 eV.

The cathode 15 is formed of an electroconductive material. Specifically, the cathode 15 may be formed of any of the electroconductive material for the anode 11 listed above. Other examples of the electroconductive material for the cathode 15 include lithium, sodium, magnesium, gold, silver, copper, aluminum, indium, calcium, tin, ruthenium, titanium, manganese, chromium, yttrium, an aluminum-calcium alloy, an aluminum-lithium alloy, an aluminum-magnesium alloy, a magnesium-silver alloy, a magnesium-indium alloy, a lithium-indium alloy, a sodium-potassium alloy, a mixture of magnesium and copper, and a mixture of aluminum and aluminum oxide. The cathode 15 may be made of a single material or of two or more materials. For example, if made of magnesium with 5 to 10% of silver or copper added thereto, the cathode 15 is less likely to be oxidized and can be brought into closer contact with the organic layer 20.

Alternatively, the cathode 15 may be formed by combining two or more similar materials or different materials. For example, to prevent oxidation of the cathode 15, a protective layer of metal having corrosion resistance such as silver and aluminum may be formed on a surface of the cathode 15 that does not contact the organic layer 20. Alternatively, to decrease the work function of the cathode 15, a layer made of any of an oxide, a fluoride, a metal, and a compound that have small work functions may be formed on a surface of the cathode 15 that contacts the organic layer 20. For example, if the cathode 15 is made of aluminum, a layer made of lithium fluoride or lithium oxide may be formed on a surface of the cathode 15 that contacts the organic layer 20.

The cathode 15 is formed by a conventional method for forming thin films, such as vacuum deposition, sputtering, ionized deposition, ion plating, and electronic beam evaporation. The thickness of the cathode 15 is preferably between 5 nm and 1 µm, more preferably between 10 nm and 500 nm, and most preferably between 50 nm and 200 nm. The electric resistance of the cathode 15 is preferably equal to or less than several hundreds of ohms/sheet.

If the organic electroluminescent device 10 is a top emission type or a top-and-bottom emission type, the cathode 15 must permit light emitted by the light emitting layer 13 to pass through. In this case, the light transmittance of the cathode 15 is preferably equal to or more than 50%. When configured to pass through light emitted by the light emitting layer 13, the cathode 15 is formed, for example, by laminating a transparent conductive oxide on a super thin film made of a magnesium-silver alloy. If the conductive oxide is laminated by sputtering, a buffer layer containing copper phthalocyanine is preferably provided between the cathode 15 and the organic layer 20 to prevent the light emitting layer 13 and other components from being damaged by plasma. On the other hand, if the organic electroluminescent device 10 is a bottom emission type, the cathode 15 is preferably capable of reflecting light emitted by the light emitting layer 13. If the device 10 is a bottom emission type and the cathode 15 passes through light emitted by the .light emitting layer 13, it is preferable that a reflection layer that reflects light emitted by the light emitting layer 13 be formed on a surface of the cathode 15 that is opposite from a surface facing the organic layer 20.

The drive unit 3 is electrically connected to the anode 11 and the cathode 15 and supplies current to the organic electroluminescent element 1 so that the light emitting layer 13 emits light. The drive unit 3 supplies to the organic electroluminescent element 1 a current pulse having a modulated pulse width and a constant amplitude. Examples of such a control include time gradation control such as the display-period-separated (DPS) method and the simultaneous-erasing-scan (SES) method.

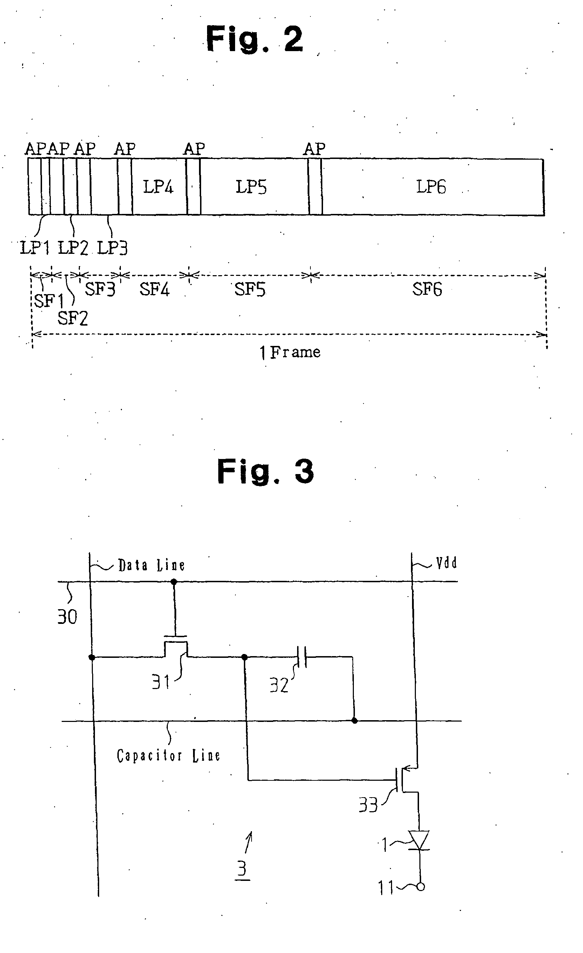

In the DPS method, the organic electroluminescent element 1 is controlled according to frames of time. "Frame" refers to a unit of time that has a predetermined length of time and is divided into two or more sub-frames. Each sub-frame corresponds to a pulse having a predetermined length of time, or a width. In every sub-frame, the electroluminescent element 1 is switched by the drive unit 3 to either one of a light emitting state or a no light emitting state. For example, in an example of Fig. 2, one frame is divided into six sub-frames SF1-SF6. The sub-frames SF1-SF6 each include an addressing period AP having a predetermined length and one of lighting periods LP1-LP6. The lengths of the lighting periods LP1-LP6 are different from one another. If the length of LP1 is one, the lengths of LP1-LP6 are two, four, eight, sixteen, and thirty-two, respectively. In every one of the lighting periods LP1-LP6, the organic electroluminescent element 1 is switched to either the light emitting state or the no light emitting state. Accordingly, the length of time during which the element 1 emits light in a single frame is changed in degrees of the sixth power of two, or in sixty four degrees. Therefore, in the example shown in Fig. 2, the organic electroluminescent element 1 is capable of expressing sixty four gradations.

If the DPS method is adopted, each pixel or each sub-pixel of the organic electroluminescent element 1 has a drive unit 3 of two transistors as shown in Fig. 3. A typical pixel includes sub-pixels of red, blue, and green. During any addressing period AP, a switching TFT 31 is turned on by a select line 30, and a capacitor 32 receives a signal voltage Vdd. Simultaneously, the potential of the anode 11 is raised to the potential as the signal potential. As a result, no current is supplied to the organic electroluminescent element 1 by a drive TFT 33, and the element 1 emits no light. During any of the lighting periods LP, the potential of the anode 11 is lowered below the signal potential. As a result, a current is supplied to the organic electroluminescent element 1 by the drive TFT 33, and the element 1 emits light.

The SES method is an improvement of the DPS method.

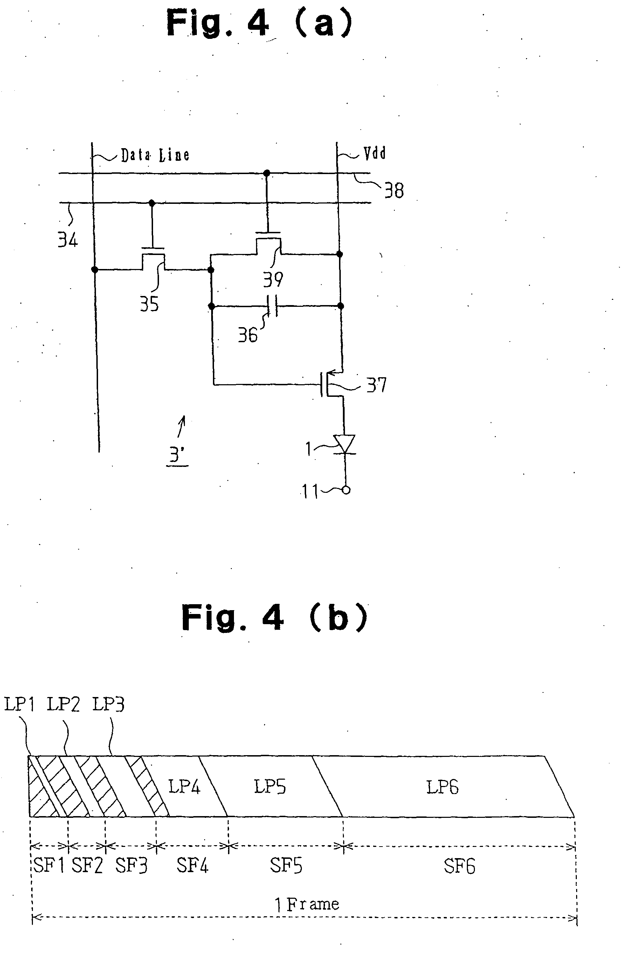

In the SES method also, each of frames that have a predetermined length of time are divided into two or more sub-frames, and in every sub-frame the electroluminescent element 1 is switched by a drive unit 3' (see Fig. 4(a)) to one of a light emitting state and a no light emitting state. For example, in an example of Fig. 4(b), one frame is divided into six sub-frames SF1-SF6. The sub-frames SF1-SF6 each include one of lighting periods LP1-LP6. The lengths of the lighting periods LP1-LP6 are different from one another. Each of the sub-frames SF1-SF3 further has a non-lighting period (hatched sections in Fig 4(b)). If the lengths of the lighting periods LP1-LP6 in Fig. 4(b) are each equal to the ' length of the corresponding one of the lighting periods LP1-LP6 in Fig. 2, the frame of Fig. 4(b) is shorter than the frame of Fig. 2. If the length of the frame of Fig. 4(b) is the same as that of the frame of Fig. 2, the drive frequency of the example shown in Fig. 4(b) is lower than that of the example shown in Fig. 2.

If the SES method is adopted, each pixel or each sub-pixel of the organic electroluminescent element 1 has a drive unit 3' of three transistors as shown in Fig. 4(a). When a select line 34 of the drive unit 3' is selected, a switching TFT 35 is turned on, and the LOW potential is applied to the gate of a drive TFT 37. Accordingly, the drive TFT 37 is turned on to charge a capacitor 36, and the organic electroluminescent element 1 emits light. When a predetermined period of time (LP1-LP6) has elapsed from the start of the light emission, a blanking signal is sent to a switching TFT 39 through an ES line 38. This turns the switching TFT 39 on, and a HIGH potential is applied to the gate of the drive TFT 37. Accordingly, the drive TFT 37 is turned off and the light emission by the organic electroluminescent element 1 is suspended. Also, the accumulated charge of the capacitor 36 is reset to zero. In a relatively long sub-frame like the sub-frames SF4-SF6, the blanking signal is not necessarily used. That is, since each sub-frame is sufficiently long compared to the time required for scanning along the rows, no non-lighting period is required.

The configurations of the drive units 3, 3' are not limited to those illustrated in Figs. 3 and 4(a). The organic electroluminescent device 10 may be driven by an active matrix system or by a passive matrix system.

In the case of the organic electroluminescent device 10 according to the first embodiment, the gradation of light emitted by the organic electroluminescent element 1 is not controlled by adjusting the current density of the current supplied to the element 1. However, the gradation of light emitted by the element 1 is controlled by the time gradation method. In this case, the organic electroluminescent device 10 is capable of changing the gradation of light emitted by the element 1 without changing the chromaticity of the light.

The first embodiment may be modified as follows.

The anode 11, the organic layer 20, and the cathode 15 may be provided on the substrate 2 in an inverse order relative to the order shown in Fig. 1. That is, the cathode 15 may be placed on the substrate 2, the organic layer 20 may be provided on the cathode 15, and the anode 11 may be provided on the organic layer 20.

At least one of the hole injection transport layer 12 and the electron injection transport layer 14 may be omitted.

The hole injection transport layer 12 between the anode 11 and the light emitting layer 13 may be replaced by a hole injection layer and a hole transport layer. In this case, the hole injection layer receives holes injected from the anode 11, and the hole transport layer transports the holes to the light emitting layer 13.

The electron injection transport layer 14 between the cathode 15 and the light emitting layer 13 may be replaced by an electron injection layer and an electron transport layer. In this case, the electron injection layer receives electrons from the cathode 15, and the electron transport layer transports the electrons to the light emitting layer 13.

The organic layer 20 may have an additional layer other than the hole injection transport layer 12, the light emitting layer 13, and the electron injection transport layer 14. The additional layer may be a layer that promotes intimate contact between the anode 11 and the hole injection transport layer 12 or between the electron injection transport layer 14 and the cathode 15. The additional layer may be a layer that promotes the injection of holes or electrons.

For example, a cathode surface layer may be provided between the electron injection transport layer 14 and the cathode 15. The cathode surface layer lowers the energy barrier against the injection of electrons from the cathode 15 to the electron injection transport layer 14, and improves the intimate contact between the electron injection transport layer 14 and the cathode 15. The cathode surface layer is made, for example, of a fluoride, an oxide, a chloride or a sulfide of an alkali metal or of an alkaline earth metal. Specifically, the cathode surface layer may be made of lithium fluoride, lithium oxide, magnesium fluoride, calcium fluoride, strontium fluoride, or barium fluoride. The cathode surface layer may be made of a single material or of two or more materials. For example, the cathode surface layer may be formed by co-deposition of the material forming the electron injection transport layer 14 and the material forming the cathode 15. The thickness of the cathode surface layer is preferably between 0.1 nm and 10 nm, and more preferably between 0.3 nm and 3 nm. The cathode surface layer may have either an even thickness or an uneven thickness. The cathode surface layer may be shaped like islands. The cathode surface layer is formed by a conventional method for forming thin films, such as vacuum deposition.

The organic electroluminescent element 1 may have another additional layer other than the anode 11, the organic layer 20, and the cathode 15. For example, the organic electroluminescent element 1 may be covered by a protective layer that seals the element 1 against oxygen and water. The protective layer is formed, for example, of a high polymeric organic material, an inorganic material, or a photosetting resin. The protective layer may be made of a single material or of two or more materials. The protective layer may consist of a single layer or of two or more layers. Examples of the high polymeric organic material include a fluororesin, an epoxy resin, a silicone resin, an epoxy silicone resin, polystyrene, polyester, polycarbonate, polyamide, polyimide, polyamideimide, polyparaxylene, polyethylene, and polyphenyleneoxide. Examples of the inorganic material include a diamond film, amorphous silica, electrical insulation glass, metal oxide, metal nitride, metal carbide, and metal sulfide.

To prevent contact with oxygen and water, the organic electroluminescent element 1 may be sealed in an inert substance such as paraffin, liquid paraffin, silicone oil, fluorocarbon oil, and fluorocarbon oil with added zeolite.

The hole injection transport layer 12 or the electron injection transport layer 14 may contain a fluorescent material or a phosphorescent material. In this case, the hole injection transport layer 12 or the electron injection transport layer 14 can emit light.

When the cathode 15 is made of metal such as aluminum, the electron injection transport layer 14 may be doped with alkali metal or an alkali metal compound to lower the energy barrier between the cathode 15 and the electron injection transport layer 14. The doped alkali metal or alkali metal compound reduces the compound constituting the electron injection transport layer 14. As a result, anion is generated in the electron injection transport layer 14. This promotes injection of electrons from the cathode 15 to the electron injection transport layer 14. The required voltage is thus lowered. Examples of the alkali metal compound include oxide, fluoride, and lithium chelate.

Instead of the time gradation control, the organic electroluminescent element 1 may be controlled by the area gradation control. In the area gradation control, each sub-pixel (or each pixel) is divided into two or more sections. Each section of the sub-pixel is independently switched between the light emitting state and the no light emitting state by the drive unit 3. For example, in an example of Fig. 5, one sub-pixel 50 is divided into sections 51-59. In this case, by switching each of the sections 51-59 to the light emitting state and the no light emitting state, the brightness of the sub-pixel 50 is changed in nine degrees. Therefore, in the example shown in Fig. 5, the organic electroluminescent element 1 is capable of expressing ten gradations. In this case, the gradation of light emitted by the organic electroluminescent element 1 is controlled by the area gradation method. Thus, the organic electroluminescent device 10 is capable of changing the gradation of light emitted by the element 1 without changing the chromaticity of the light.

In addition to the time gradation control, the organic electroluminescent element 1 may also be controlled by the area gradation control. In this case, each of the frames that have a predetermined length is divided into two or more sub-frames, and each sub-pixel (or each pixel) is divided into two or more sections. Each section of the sub-pixel is independently switched between the light emitting state and the no light emitting state by the drive unit 3. Compared to a case where only of the time gradation control or the area gradation control is adopted, a greater number of gradations can be expressed. In this case, the gradation of light emitted by the organic electroluminescent element 1 is controlled by the time gradation method and the area gradation method. Thus, the organic electroluminescent device 10 is capable of changing the gradation of light emitted by the element 1 without changing the chromaticity of the light.

A second embodiment of the present invention will now be described.

An organic electroluminescent device of the second embodiment is different from the organic electroluminescent device 10 of the first embodiment in the configuration of a light emitting layer. The light emitting layer of the device according to the second embodiment is a single electroluminescent layer that contains a host material and at least two types of doped phosphorescent materials that emit light of different colors from each other.

In the case of the organic electroluminescent device according to the second embodiment, the gradation of light emitted by the organic electroluminescent element is not controlled by adjusting the current density of the current supplied to the element. However, the gradation of light emitted by the element is controlled by the time gradation method or the area gradation method. Thus, the organic electroluminescent device is capable of changing the gradation of light emitted by the element without changing the chromaticity of the light.

A third embodiment of the present invention will now be described.

An organic electroluminescent device of the third embodiment is also different from the organic electroluminescent device 10 of the first embodiment in the configuration of a light emitting layer. Instead of a phosphorescent material, each of electroluminescent layers of the organic electroluminescent device of the third embodiment contains a fluorescent material (fluorescent pigment, fluorescent dopant). The fluorescent material receives energy from the host material and generates singlet excitons. The generated singlet excitons emit light during transition to the ground state at ordinary temperatures. The fluorescent material preferably has a high fluorescent quantum efficiency. The doping ratio of the fluorescent material to the host material is preferably between 0.01 wt% . and 5 wt%.

The host material contained in the electroluminescent layer that emits red light, green light, or yellow light is preferably any of a distyrylallylene derivative, a distyrylbenzene derivative, a distyrylamine derivative, a quinolinolato metal complex, a triarylamine derivative, an oxiadiazole derivative, a silole derivative, a dicarbazole derivative, an oligothiophene derivative, a benzopyran derivative, a triazole derivative, a benzoxazole derivative, and a benzothiazole derivative. More preferably, the host material is Alq3, tetramer of triphenylamine, or 4,4'-bis(2,2'-diphenylvinyl) (DPVBi). The host material contained in the electroluminescent layer that emits blue light is preferably a distyrylallylene derivative, a stilbene derivative, a carbazole derivative, a triarylamine derivative, or bis(2-methyl-8-quinolinolato)(p-phenylphenolato)aluminum.

Examples of the fluorescent material contained in the electroluminescent layer that emits red light include an europium complex, a benzopyran derivative, a rhodamine derivative, a benzothioxanthene derivative, a porphyrin derivative, Nile red, 2-(1,1-dimethylethyl)-6-(2-(2,3,6,7-tetrahydro-1,1,7,7-tetramethyl-1H,5H-benzo(ij)quinolizine-9-yl)ethenyl-4H-pyran-4H-ylidene)propanedinitrile(DCJTB), and DCM. Examples of the fluorescent material contained in the electroluminescent layer that emits green light include a coumarin derivative and a quinacridone derivative. The examples of the fluorescent material contained in the electroluminescent layer that emits blue light include a distyrylamine derivative, a pyrene derivative, a perylene derivative, an anthracene derivative, a benzoxazole derivative, a benzothiazole derivative, a benzimidazole derivative, a chrysene derivative, a phenanthrene derivative, a distyrylbenzene derivative, and a tetraphenylbutadiene derivative. Examples of the fluorescent material contained in the electroluminescent layer that emits yellow light include a rubrene derivative.

Each electroluminescent layer is formed by a conventional method for forming thin films, such as vacuum deposition, spin coating, casting, and the LB method. The thickness of each electroluminescent layer is preferably between 1 nm and 100 nm, and more preferably between 2 nm and 50 nm.

In the organic electroluminescent device according to the third embodiment, the current pulse supplied from the drive unit to the organic electroluminescent element has a current density that is equal to or more than 1 A/cm². However, the gradation of light emitted by the organic electroluminescent element is not controlled by adjusting the current density, but is controlled by the time gradation method or the area gradation method. Thus, the organic electroluminescent device is capable of changing the gradation of light emitted by the element without changing the chromaticity of the light.

A fourth embodiment of the present invention will now be described.

An organic electroluminescent device of the fourth embodiment is also different from the organic electroluminescent device 10 of the first embodiment in the configuration of a light emitting layer. The light emitting layer of the device according to the fourth embodiment is a single electroluminescent layer that contains a host material and at least two types of fluorescent materials that emit light of different colors from each other. The details of the host material and the fluorescent material are the same as those in the third embodiment, and thus the description thereof is omitted.

In the organic electroluminescent device according to the fourth embodiment, the density of the current supplied from the drive unit to the organic electroluminescent element is equal to or more than 1 A/cm². However, the gradation of light emitted by the organic electroluminescent element is not controlled by adjusting the current density, but is controlled by the time gradation method or the area gradation method. Thus, the organic electroluminescent device is capable of changing the gradation of light emitted by the element without changing the chromaticity of the light.

Therefore, the present examples and embodiments are to be considered as illustrative and not restrictive and the invention is not to be limited to the details given herein, but may be modified within the scope and equivalence of the appended claims.

An organic electroluminescent device that is capable of changing the gradation of emitted light without changing the chromaticity of the light. The organic electroluminescent device according to the present invention has an organic electroluminescent element and a drive unit. The organic electroluminescent element has a pair of electrodes and an electroluminescent layer provided between the electrodes. The electroluminescent layer contains at least two types of phosphorescent materials. Each phosphorescent material emits light the color of which is different from the color of light emitted by the other phosphorescent material. The drive unit is electrically connected to the organic electroluminescent element. The drive unit supplies to the organic electroluminescent element a current that has a modulated pulse width and a constant amplitude, thereby causing the organic electroluminescent element to emit light.

## Claims

1. An organic electroluminescent device, **characterized by**:
an organic electroluminescent element, wherein the organic electroluminescent element has a pair of electrodes and an electroluminescent layer provided between the electrodes, wherein the electroluminescent layer contains at least two types of phosphorescent materials, and wherein each phosphorescent material emits light the color of which is different from the color of light emitted by the other phosphorescent material; and
a drive unit that is electrically connected to the organic electroluminescent element, wherein the drive unit supplies to the organic electroluminescent element a current that has a modulated pulse width and a constant amplitude, thereby causing the organic electroluminescent element to emit light.

2. An organic electroluminescent device, **characterized by**:
an organic electroluminescent element, wherein the organic electroluminescent element has a pair of electrodes and at least two electroluminescent layers provided between the electrodes, wherein each electroluminescent layer contains a phosphorescent material, and wherein the phosphorescent material contained in each electroluminescent layer emits light the color of which is different from the color of light emitted by the phosphorescent material of the other electroluminescent layer; and
a drive unit that is electrically connected to the organic electroluminescent element, wherein the drive unit supplies to the organic electroluminescent element a current pulse having a modulated pulse width and a constant amplitude, thereby causing the organic electroluminescent element to emit light.

3. An organic electroluminescent device, **characterized by**:
an organic electroluminescent element, wherein the organic electroluminescent element has a pair of electrodes and an electroluminescent layer provided between the electrodes, wherein the electroluminescent layer contains at least two types of fluorescent materials, and wherein each fluorescent material emits light the color of which is different from the color of light emitted by the other fluorescent material; and
a drive unit that is electrically connected to the organic electroluminescent element, wherein the drive unit supplies to the organic electroluminescent element a current pulse that has a modulated pulse width, a constant amplitude, and a current density equal to or more than 1 A/cm², thereby causing the organic electroluminescent element to emit light.

4. An organic electroluminescent device, **characterized by**:
an organic electroluminescent element, wherein the organic electroluminescent element has a pair of electrodes and at least two electroluminescent layers provided between the electrodes, wherein each electroluminescent layer contains a fluorescent material, and wherein the fluorescent material contained in each electroluminescent layer emits light the color of which is different from the color of light emitted by the fluorescent material of the other electroluminescent layer; and
a drive unit that is electrically connected to the organic electroluminescent element, wherein the drive unit supplies to the organic electroluminescent element a current pulse that has a modulated pulse width, a constant amplitude, and a current density equal to or more than 1 A/cm², thereby causing the organic electroluminescent element to emit light.

5. The organic electroluminescent device according to any one of claims 1 to 4, **characterized in that** the drive unit controls the gradation of brightness of the organic electroluminescent element by a time gradation method.

6. The organic electroluminescent device according to any one of claims 1 to 4, **characterized in that** the drive unit controls the gradation of brightness of the organic electroluminescent element by a time gradation method and an area gradation method.

7. An organic electroluminescent device, **characterized by**:
an organic electroluminescent element, wherein the organic electroluminescent element has a pair of electrodes and an electroluminescent layer provided between the electrodes, wherein the electroluminescent layer contains at least two types of phosphorescent materials, wherein each phosphorescent material emits light the color of which is different from the color of light emitted by the other phosphorescent material; and
a drive unit that is electrically connected to the organic electroluminescent element, wherein the drive unit controls the gradation of brightness of the organic electroluminescent element by an area gradation method.

8. An organic electroluminescent device, **characterized by**:
an organic electroluminescent element, wherein the organic electroluminescent element has a pair of electrodes and at least two electroluminescent layers provided between the electrodes, wherein each electroluminescent layer contains a phosphorescent material, and wherein the phosphorescent material contained in each electroluminescent layer emits light the color of which is different from the color of light emitted by the phosphorescent material of the other electroluminescent layer; and
a drive unit that is electrically connected to the organic electroluminescent element, wherein the drive unit controls the gradation of brightness of the organic electroluminescent element by an area gradation method.

9. An organic electroluminescent device, **characterized by**:
an organic electroluminescent element, wherein the organic electroluminescent element has a pair of electrodes and an electroluminescent layer provided between the electrodes, wherein the electroluminescent layer contains at least two types of fluorescent materials, and wherein each fluorescent material emits light the color of which is different from the color of light emitted by the other fluorescent material; and
a drive unit that is electrically connected to the organic electroluminescent element, wherein the drive unit controls the gradation of brightness of the organic electroluminescent element by an area gradation method.

10. An organic electroluminescent device, **characterized by**:
an organic electroluminescent element, wherein the organic electroluminescent element has a pair of electrodes and at least two electroluminescent layers provided between the electrodes, wherein each electroluminescent layer contains a fluorescent material, and wherein the fluorescent material contained in each electroluminescent layer emits light the color of which is different from the color of light emitted by the fluorescent material of the other electroluminescent layer; and
a drive unit that is electrically connected to the organic electroluminescent element, wherein the drive unit controls the gradation of brightness of the organic electroluminescent element by an area gradation method.

11. The organic electroluminescent device according to any one of claims 7 to 10, **characterized in that** the current supplied from the drive unit to the organic electroluminescent element has a constant current density.
